# EUROPEAN PATENT APPLICATION

(11) **EP 4 096 083 A1**
(43) Date of publication of application: **30.11.2022**
(21) Application number: 21744904.0
(22) Date of filing: 13.01.2021
(51) Int. Cl.: H02M 3/155, H02M 3/07, H02M 7/48

(54) **BOOSTER CIRCUIT AND VOLTAGE GENERATION DEVICE**

(30) Priority: 24.01.2020 JP 2020009971
(71) Applicant: MITSUBISHI ELECTRIC CORPORATION, Chiyoda-ku Tokyo 100-8310 (JP)
(72) Inventor: IZAWA, Fumihito, Tokyo 100-8310 (JP); YAMASHITA, Yuya, Tokyo 100-8310 (JP); ARAKI, Yohei, Tokyo 100-8310 (JP); ACHIHARA, Masato, Amagasaki-shi, Hyogo 661-0001 (JP)
(74) Representative: Diehl & Partner
(86) International application number: PCT/JP2021/000887
(87) International publication number: WO 2021/149562

(57) **Abstract**

A CW circuit that is a booster circuit includes an insulating substrate (10A) having a first component disposed on an upper surface and a second component disposed on a lower surface, an insulating substrate (10B) having a third component disposed on an upper surface, and a lead (9A) connected to the second component, in which the insulating substrates (10A, 10B) are stacked such that the lower surface of the insulating substrate (10A) faces the upper surface of the insulating substrate (10B), a copper foil pattern (11A) for connecting the lead (9A) to a conductive member disposed on the insulating substrate (10A) is placed on at least one of the upper surface and the lower surface of the insulating substrate (10A), and the copper foil pattern (11A) is spread to a region covering a lead forming portion (21A) of the lead (9A) when viewed from a side of the upper surface of the insulating substrate (10A).

## Description

### Field

The present invention relates to a booster circuit that boosts a voltage and a voltage generator.

### Background

A voltage generator used in accelerating an electron beam in an electron beam machine, an ion beam generator, an electron microscope, or the like includes a Cockcroft-Walton (CW) circuit as a circuit that converts an alternating current voltage into a direct current voltage. This voltage generator includes a stack of a plurality of insulating substrates including booster circuits, and the booster circuits boost a voltage in stages to generate a direct current high voltage.

The booster circuit of the voltage generator includes a component having a low withstand voltage, but the voltage increases as it nears an output part thereof. This results in a large potential difference between a low-voltage part and a high-voltage part, and discharge is likely to occur, for example, between the insulating substrates. In order to prevent the occurrence of such discharge, it is necessary to sufficiently secure the insulation tolerance, but an increase in the insulation tolerance results in an increase in size of the voltage generator.

A voltage generator described in Patent Literature 1 achieves downsizing thereof while improving the insulation tolerance between insulating substrates and the like by integrally molding electronic components at each stage of a booster circuit with a resin molding material.

### Citation List

### Patent Literature

Patent Literature 1: Japanese Patent Application Laid-open No. H7-312300

### Summary

### Technical Problem

However, in the technique of Patent Literature 1 above, since the electronic components are integrally molded with the resin molding material, there has been a problem that the booster circuit is heavy.

The present invention has been made in view of the above, and an object thereof is to provide a booster circuit that is downsized without an increase in weight of a plurality of insulating substrates being stacked.

### Solution to Problem

In order to solve the above problem and achieve the object, the present invention is a booster circuit that boosts an input voltage and includes: a first insulating substrate having a first component disposed on a first main surface and a second component disposed on a second main surface; and a second insulating substrate having a third component disposed on a third main surface. The booster circuit further includes a first lead connected to the second component and a connection line that connects the first insulating substrate and the second insulating substrate. In the booster circuit, the first insulating substrate and the second insulating substrate are stacked such that the second main surface faces the third main surface. Moreover, in the booster circuit, a first conductive pattern that connects the first lead to a conductive member disposed on the first insulating substrate is placed on at least one of the first main surface and the second main surface, and when the first insulating substrate is viewed from a side of the first main surface, the first conductive pattern is spread to a region covering a first lead forming portion that is a bent portion of the first lead.

### Advantageous Effects of Invention

According to the present invention, an effect is obtained whereby the booster circuit that is downsized without an increase in weight of the plurality of insulating substrates being stacked can be provided.

### Brief Description of Drawings

FIG. 1 is a diagram illustrating a configuration of a CW circuit included in a voltage generator according to a first embodiment.
FIG. 2 is a diagram for explaining the operating principle of the CW circuit included in the voltage generator according to the first embodiment.
FIG. 3 is a diagram illustrating an implementation structure of the CW circuit included in the voltage generator according to the first embodiment.
FIG. 4 is a diagram for explaining a potential difference between stages of the CW circuit included in the voltage generator according to the first embodiment.
FIG. 5 is a perspective view illustrating a structure of the stage included in the voltage generator according to the first embodiment.
FIG. 6 is a side view illustrating a structure of the stage included in the voltage generator according to the first embodiment.
FIG. 7 is a diagram for explaining a positional relationship between the stages included in the voltage generator according to the first embodiment.
FIG. 8 is a diagram for explaining a distance between components of the stages illustrated in FIG. 7.
FIG. 9 is an enlarged view of a part where a capacitor is disposed in the stage on an upper side illustrated in FIG. 8.
FIG. 10 is an enlarged view of a part where a diode is disposed in the stage on a lower side illustrated in FIG. 8.
FIG. 11 is a diagram for explaining formation of copper foil patterns of the stages included in the voltage generator according to the first embodiment.
FIG. 12 is a diagram for explaining formation of copper foil patterns of stages included in a voltage generator of a comparative example.
FIG. 13 is a diagram for explaining an electric field simulation model for lead forming portions of leads included in the voltage generator according to the first embodiment.
FIG. 14 is a table illustrating a result of simulation using the electric field simulation model of FIG. 13.
FIG. 15 is a diagram for explaining a configuration of stages included in a voltage generator according to a second embodiment.
FIG. 16 is a diagram for explaining an electric field simulation model for lead forming portions of leads included in the voltage generator according to the second embodiment.
FIG. 17 is a table illustrating a result of simulation using the electric field simulation model of FIG. 16.
FIG. 18 is a diagram for explaining an example of another configuration of a stage included in the voltage generator according to the second embodiment.
FIG. 19 is a diagram for explaining electric field concentration in a case where the copper foil pattern according to the first embodiment is placed on either an upper surface or a lower surface of an insulating substrate, and where an outer shape of the copper foil pattern is a quadrangle.
FIG. 20 is a diagram for explaining electric field concentration in a case where the copper foil pattern according to the first embodiment is placed on either the upper surface or the lower surface of the insulating substrate, and where an outer shape of the copper foil pattern is a circle.
FIG. 21 is a diagram for explaining electric field concentration in a case where the copper foil pattern according to the first embodiment is placed on both surfaces of the insulating substrate, and where an outer shape of the copper foil pattern is a quadrangle.
FIG. 22 is a diagram for explaining electric field concentration in a case where the copper foil pattern according to the first embodiment is placed on both surfaces of the insulating substrate, and where an outer shape of the copper foil pattern is a circle.
FIG. 23 is a diagram illustrating formation of copper foil patterns according to a third embodiment.
FIG. 24 is a top view illustrating formation of a copper foil pattern according to a fourth embodiment.
FIG. 25 is a perspective view illustrating formation of the copper foil pattern according to the fourth embodiment.
FIG. 26 is a perspective view illustrating formation of the copper foil pattern when the copper foil pattern illustrated in FIG. 25 is cut along line B-B.

### Description of Embodiments

Hereinafter, embodiments of a booster circuit and a voltage generator according to the present invention will be described in detail with reference to the drawings. Note that the present invention is not limited to these embodiments. In the following description, a Cockcroft-Walton circuit included in the voltage generator is referred to as a CW circuit.

### First Embodiment.

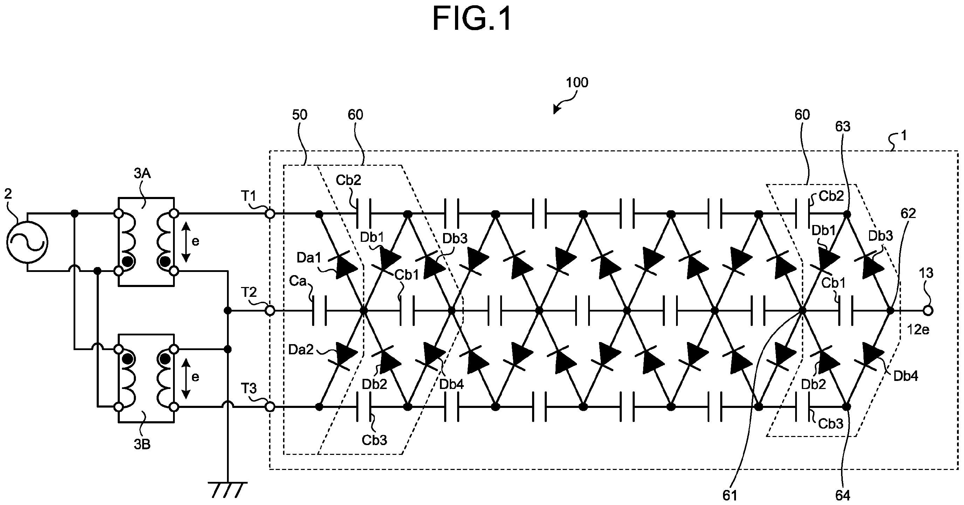

FIG. 1 is a diagram illustrating a configuration of a CW circuit included in a voltage generator according to a first embodiment. A voltage generator 100 that is a direct current high voltage generator includes a CW circuit 1 that is a booster circuit, step-up transformers 3A and 3B, and an inverter circuit 2 that generates an alternating current voltage. Here, a case where the CW circuit 1 is a symmetric inverse CW circuit will be described.

The voltage generator 100 generates a voltage of several tens of kV to several hundreds of kV using the CW circuit 1, for example. A direct current high voltage generated by the voltage generator 100 is used, for example, when an electron beam machine that performs machining by irradiating an object with an electron beam accelerates the electron beam. The direct current high voltage generated by the voltage generator 100 may also be applied to an ion beam generator, an electron microscope, or the like.

The CW circuit 1 is a multi-stage voltage doubler rectifier circuit. While each component of the CW circuit 1 is a component having a low withstand voltage, the CW circuit 1 boosts the voltage to output a high voltage from an output part 13, so that the voltage on the CW circuit 1 increases as it nears the output part 13. Note that a boosting method, a boosting ratio, a voltage value, and the like of the CW circuit 1 described here are examples. The CW circuit 1 may be a CW circuit employing any boosting method.

The symmetric inverse CW circuit 1 is connected to the two step-up transformers 3A and 3B connected to the inverter circuit 2. The inverter circuit 2 is a full bridge inverter including a switching element such as an insulated gate bipolar transistor (IGBT) or a metal-oxide-semiconductor field-effect transistor (MOSFET). The inverter circuit 2 is driven at a frequency on the order of kHz.

The step-up transformers 3A and 3B step up the output of the inverter circuit 2 from minus several kV to minus several tens of kV (for example, -10 kV). The step-up transformers 3A and 3B each include a primary winding and a secondary winding, and the secondary windings of the step-up transformers 3A and 3B are connected in series with each other. The polarities of the windings of the step-up transformers 3A and 3B are indicated by black dots. The secondary windings of the step-up transformers 3A and 3B are connected to each other on the side of the black dots.

Both terminals of the secondary winding of the step-up transformer 3A serve as input terminals T1 and T2 of the CW circuit 1. Both terminals of the secondary winding of the step-up transformer 3B serve as input terminals T2 and T3 of the CW circuit 1. The input terminal T2 is connected to a fixed potential.

The CW circuit 1 includes a plurality of diodes and a plurality of capacitors. Specifically, the CW circuit 1 includes a rectifier circuit unit 50 and a voltage doubler booster circuit unit 60. The rectifier circuit unit 50 includes a direct current capacitor Ca and diodes Da1 and Da2, and the voltage doubler booster circuit unit 60 includes a direct current capacitor Cb1, alternating current capacitors Cb2 and Cb3, and diodes Db1 to Db4.

In the inverse CW circuit 1, a first capacitor and a first diode when viewed from an input side are omitted, and thus the circuit of a first stage simply forms the rectifier circuit unit 50. The rectifier circuit unit 50 is connected to the input terminals T1 to T3, and the voltage doubler booster circuit unit 60 is connected to the rectifier circuit unit 50 and the output part 13. In the rectifier circuit unit 50, the direct current capacitor Ca is connected to the input terminal T2, a cathode of the diode Da1 is connected to the input terminal T1, and a cathode of the diode Da2 is connected to the input terminal T3.

In the CW circuit 1, a plurality of the voltage doubler booster circuit units 60 are connected in stages to the rectifier circuit unit 50. That is, in the CW circuit 1, the plurality of the voltage doubler booster circuit units 60 each including the direct current capacitor Cb1, the alternating current capacitors Cb2 and Cb3, and the diodes Db1 to Db4 are connected in stages to the direct current capacitor Ca and the diodes Da1 and Da2 included in the rectifier circuit unit 50. This configuration makes the CW circuit 1 the multi-stage voltage doubler rectifier circuit. The capacitance of the direct current capacitor Ca of the rectifier circuit unit 50 is set to be twice the capacitance of the direct current capacitor Cb1 included in the voltage doubler booster circuit unit 60.

Assuming that the voltage doubler booster circuit unit 60 of an N-th stage (where "N" is a natural number) among the voltage doubler booster circuit units 60 is denoted as a voltage doubler booster circuit unit 60-N, the voltage doubler booster circuit unit 60-N and a voltage doubler booster circuit unit 60-(N-1) are connected. Here, a configuration of the voltage doubler booster circuit unit 60-N will be described in a case where the voltage doubler booster circuit unit 60-N is disposed on the side closer to the output part 13.

In the voltage doubler booster circuit unit 60-N that is a unit circuit, a cathode of the diode Db1 and a cathode of the diode Db2 are connected at a connection point 61. Moreover, an anode of the diode Db3 and an anode of the diode Db4 are connected at a connection point 62. In addition, an anode of the diode Db1 and a cathode of the diode Db3 are connected at a connection point 63, and an anode of the diode Db2 and a cathode of the diode Db4 are connected at a connection point 64. The direct current capacitor Cb1 is connected to the connection point 61 and the connection point 62.

The alternating current capacitor Cb2 of the voltage doubler booster circuit unit 60-N is connected to the connection point 63 of the voltage doubler booster circuit unit 60-N and the connection point 63 of the voltage doubler booster circuit unit 60-(N-1). The alternating current capacitor Cb3 of the voltage doubler booster circuit unit 60-N is connected to the connection point 64 of the voltage doubler booster circuit unit 60-N and the connection point 64 of the voltage doubler booster circuit unit 60-(N-1). The connection point 61 of the voltage doubler booster circuit unit 60-N is the connection point 62 of the voltage doubler booster circuit unit 60-(N-1).

The voltage doubler booster circuit unit 60 of a first stage is connected to the voltage doubler booster circuit unit 60 of a second stage and the rectifier circuit unit 50. In the voltage doubler booster circuit unit 60 of the first stage, the alternating current capacitor Cb2 is connected to the input terminal T1 and the cathode of the diode Da1, and the alternating current capacitor Cb3 is connected to the input terminal T3 and the cathode of the diode Da2. Also, in the voltage doubler booster circuit unit 60 of the first stage, the connection point 61 is connected to the direct current capacitor Ca.

The voltage that the CW circuit 1 outputs from the output part 13 is used as, for example, a high voltage for electron beam generation. At this time, a voltage V output from the output part 13 is expressed as V=(2n-1)e, where "e" is a peak value of the output voltage of the step-up transformers 3A and 3B. Here, "n" represents the number of series of the voltage doubler booster circuit units 60. FIG. 1 illustrates a case where the total number of series of the voltage doubler booster circuit units 60 is six and a half, and the CW circuit 1 is a 12-fold booster circuit.

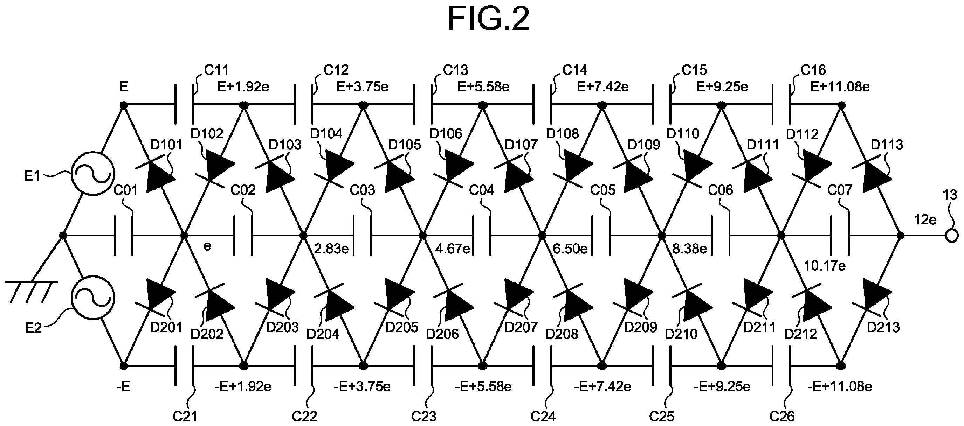

Next, the operating principle of the CW circuit 1 will be described. FIG. 2 is a diagram for explaining the operating principle of the CW circuit included in the voltage generator according to the first embodiment. In FIG. 2, the diodes Db1 and Db3 in the CW circuit 1 are indicated by diodes D102, D103,..., and D113 in order from the voltage input side, and the diodes Db2 and Db4 in the CW circuit 1 are indicated by diodes D202, D203,..., and D213 in order from the voltage input side. Moreover, the direct current capacitors Cb1 in the CW circuit 1 are indicated by direct current capacitors C02, C03,..., and C07 in order from the voltage input side. In addition, the alternating current capacitors Cb2 in the CW circuit 1 are indicated by alternating current capacitors C11, C12,..., and C16 in order from the voltage input side, and the alternating current capacitors Cb3 in the CW circuit 1 are indicated by alternating current capacitors C21, C22,..., and C26 in order from the voltage input side.

Moreover, the diodes Da1 and Da2 of the rectifier circuit unit 50 are indicated by diodes D101 and D201, respectively, and the direct current capacitor Ca is indicated by a direct current capacitor C01. Note that in FIG. 2, voltage values written next to the connection points in the CW circuit 1 are voltage values at the connection points.

Alternating current power supplies E1 and E2 generate sinusoidal voltages E(=esinωt) and -E(=-esinωt) having the same peak value (=e) and the phases different from each other by 180 degrees, respectively. The peak value "e" is a negative value.

At the time when the alternating current power supply E1 generates the highest voltage "e", the direct current capacitor C01 is charged to the voltage "e" via the diode D101. At this time, since the alternating current power supply E2 generates -0.92e, the alternating current capacitor C21 is charged to 1.92e via the diodes D101 and D202.

When the alternating current power supply E2 generates the voltage "e" the next time, the potential of the high-voltage terminal of the alternating current capacitor C21 equals 2.92e. With this potential, the direct current capacitors C01 and C02 connected in series are charged to a voltage of 2.92e via the diode D203. At the same time, the alternating current capacitors C11 and C12 connected in series are charged to a voltage of 2.83e via the diodes D203 and D104. When the alternating current power supply E1 generates the voltage "e" again, the direct current capacitors C01, C02, and C03 connected in series in the next stage are charged to a voltage of 4.67e via the diode D105. Such capacitor charging is repeated in the CW circuit 1, and the output of the last stage from the output part 13 equals a voltage of 12e.

The reason why the capacitance of only the direct current capacitor C01 is set twice (2C) the capacitance of the other direct current capacitors is to prevent the occurrence of a surge. For example, when rapid discharge occurs in the direct current capacitors C01 to C07 by dielectric breakdown of a load, the discharge amounts of the direct current capacitors C01 to C07 connected in series are all equal, and thus the voltage across the direct current capacitors C01 to C07 all equals "e", and for the rest the voltage equals 2e. Therefore, by setting the capacitance of only the direct current capacitor C01 in the first stage to 2C, the amount of charge in normal time all equals 2eC. As a result, even when rapid discharge occurs, the terminal voltages of the direct current capacitors C01 to C07 all equal zero with no anomaly, and the occurrence of a surge voltage is prevented.

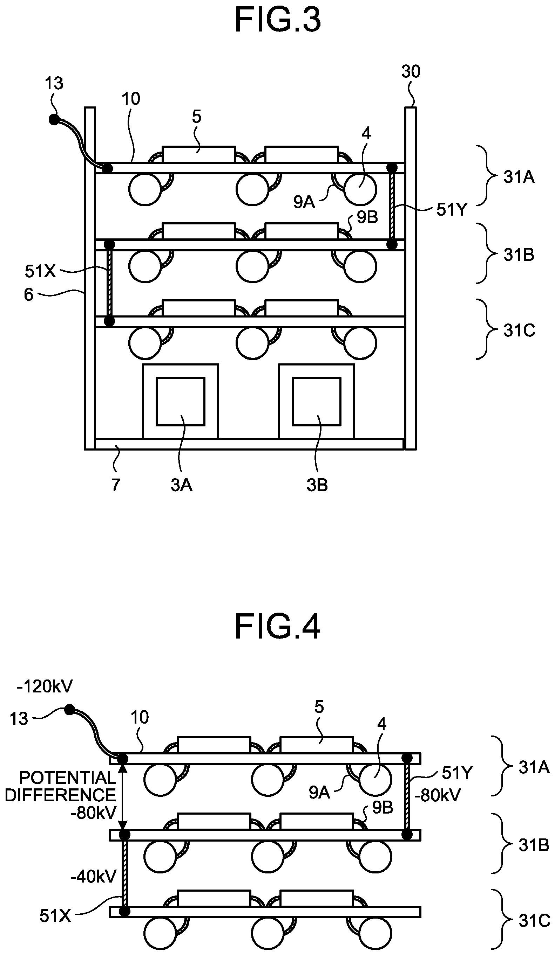

Next, an implementation structure of the CW circuit 1 will be described. FIG. 3 is a diagram illustrating the implementation structure of the CW circuit included in the voltage generator according to the first embodiment. FIG. 3 illustrates a cross-sectional view taken along a plane including a cylinder axis of a cylindrical outer peripheral container 30 in which the CW circuit is disposed. Note that in the following description, a side corresponding to a bottom surface of the outer peripheral container 30 is referred to as a lower side, and a side on which a stage 31A is disposed is referred to as an upper side.

The CW circuit 1 of the voltage generator 100 is disposed in the cylindrical outer peripheral container 30 that is grounded. A base plate 7 is provided at a bottom portion of the outer peripheral container 30, and the two step-up transformers 3A and 3B are disposed on an upper surface of the base plate 7.

In the outer peripheral container 30, a plurality of stages are disposed above the step-up transformers 3A and 3B. FIG. 3 illustrates a case where three stages 31A, 31B, and 31C are stacked at equal intervals in the outer peripheral container 30. The stage 31C is a first stage from the bottom, the stage 31B is a second stage from the bottom, and the stage 31A is a third stage from the bottom.

The stages 31A to 31C and the base plate 7 are disposed such that upper and lower surfaces thereof are parallel to one another. FIG. 3 illustrates a case where the stage 31C is disposed above the base plate 7, the stage 31B is disposed above the stage 31C, and the stage 31A is disposed above the stage 31B.

The step-up transformers 3A and 3B are electrically connected to the stage 31C. The stage 31C is electrically connected to the stage 31B via a connection line 51X, and the stage 31B is electrically connected to the stage 31A via a connection line 51Y. Note that FIG. 3 omits the illustration of a connection line between the step-up transformers 3A and 3B and a connection line between the step-up transformers 3A and 3B and the stage 31C.

The stages 31A, 31B, and 31C are each formed using an insulating substrate 10 of a plate shape, and a capacitor 4 and a diode 5 are mounted on each insulating substrate 10. A lower surface of the insulating substrate 10 of the stage 31A faces an upper surface of the insulating substrate 10 of the stage 31B, and a lower surface of the insulating substrate 10 of the stage 31B faces an upper surface of the insulating substrate 10 of the stage 31C. In the outer peripheral container 30, one of two of the insulating substrates 10 facing each other is a first insulating substrate, and the other is a second insulating substrate.

In the stages 31A to 31C, for example, the diode 5 is disposed on the upper surface of the insulating substrate 10, and the capacitor 4 is disposed on the lower surface of the insulating substrate 10. Note that any of the diode 5 and the capacitor 4 may be disposed on the upper surface and the lower surface of the insulating substrate 10 included in each of the stages 31A to 31C. In the outer peripheral container 30, the upper surface of the insulating substrate 10 and the diode 5 are connected by a lead 9B, and the lower surface of the insulating substrate 10 and the capacitor 4 are connected by a lead 9A. In the outer peripheral container 30, the output voltages from the step-up transformers 3A and 3B are stepped up in stages in the stage 31C, the stage 31B, and the stage 31A, and are output from the output part 13.

The stages 31A to 31C forming the CW circuit 1 are provided with input parts and output parts that connect the stages. FIG. 3 omits the illustration of the output parts except the output part 13 of the stage 31A and the input parts. The output part of the stage 31C and the input part of the stage 31B are provided at connection points with the connection line 51X. The output part of the stage 31B and the input part of the stage 31A are provided at connection points with the connection line 51Y.

In the CW circuit 1, the output part of the stage 31C and the input part of the stage 31B are electrically connected, and the output part of the stage 31B and the input part of the stage 31A are electrically connected.

The stages 31A to 31C being electrically connected are stacked at equal intervals as described above, whereby a stepped-up direct current high voltage is output from the output part 13 of the uppermost stage 31A. The stages 31A to 31C may be stacked with a resin spacer interposed therebetween, or may be stacked by providing a column 6 between the stages as illustrated in FIG. 3 and fixing the stages with bolts or the like via the column 6. The column 6 may be a part of the outer peripheral container 30 or may be formed separately from the outer peripheral container 30.

Here, a potential difference between the stages will be described. FIG. 4 is a diagram for explaining the potential difference between the stages of the CW circuit included in the voltage generator according to the first embodiment. Here, there will be described the potential difference between the stages in a case where an input voltage to the CW circuit 1 is stepped up to ±10 kV, that is, an output of the full bridge inverter is stepped up to ±10 kV by the step-up transformers 3A and 3B.

In the case where the input voltage to the CW circuit 1 is ±10 kV, the output voltage in the third stage reaches -120 kV when the voltage is stepped up by about -40 kV per stage. As illustrated in FIG. 4, there is a place with a potential difference of up to -80 kV between the stages. For example, the potential difference between -40 kV at the input part of the stage 31B as the second stage and -120 kV at the output part of the stage 31A as the third stage is -80 kV. Since the stages 31A to 31C are stacked at equal intervals, it can be said that the place with the maximum potential difference is the place where discharge is most likely to occur.

Here, discharge will be described. A likelihood of discharge depends on magnitude of an electric field, and the magnitude of the electric field discharged in air is about 3 kV/mm. The magnitude of the electric field is determined by a potential difference between two points, which correspond to places where discharge is likely to occur (hereinafter referred to as discharge candidates), a distance between the two points, and outer shapes of the two points. However, in a case where the two points as the discharge candidates are both infinite parallel plates, the electric field is determined only by the potential difference and the distance. This state of space is called a uniform electric field. For example, in a case where the potential difference between the two points is 3 kV and the distance between the two points is 1 mm, the magnitude of the electric field is 3 kV/mm.

On the other hand, in a case where the two points as the discharge candidates are not infinite parallel plates but protrusions (for example, needles), the magnitude of the electric field is determined by the potential difference between the two points as the discharge candidates, the distance between the two points, and the outer shapes. In a case where the potential difference and the distance are fixed, the electric field increases with an increase in acuteness of the outer shapes of the two points as the discharge candidates, and the electric field decreases as the outer shapes approximate a sphere. This state of space is called a non-uniform electric field.

In a case where the potential difference is fixed, it is necessary to increase the distance between the two points as the discharge candidates or to appropriately design the outer shapes of the two points in order to prevent the occurrence of discharge. However, simply increasing the distance results in an increase in size of the voltage generator. Therefore, in the present embodiment, the distance between the two points is reduced by appropriately designing the outer shape of at least one of the two points as the discharge candidates. That is, in the CW circuit 1, the distance between the stages is reduced.

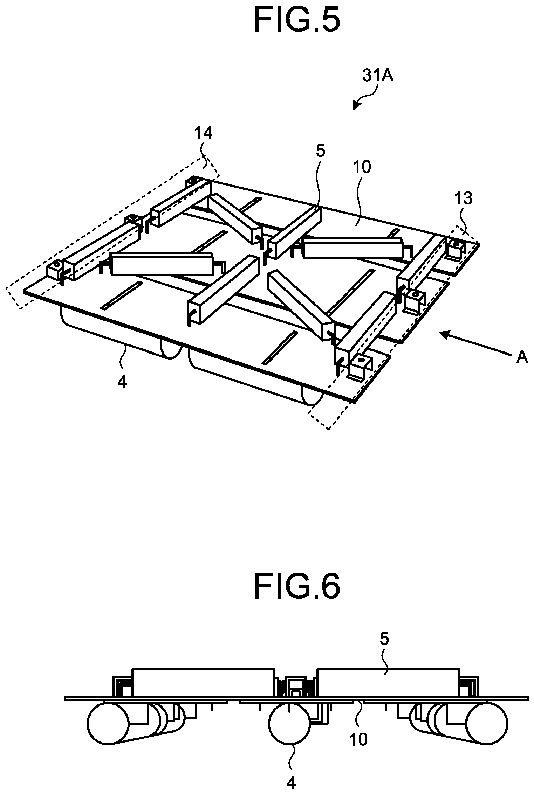

FIG. 5 is a perspective view illustrating a structure of the stage included in the voltage generator according to the first embodiment. FIG. 6 is a side view illustrating the structure of the stage included in the voltage generator according to the first embodiment. FIGS. 5 and 6 illustrate the structure for one stage. Note that since the stages 31A to 31C have similar structures, the structure of the stage 31A will be described here. FIG. 6 illustrates the structure of the stage 31A when the stage 31A is viewed from a direction indicated by "A" in FIG. 5.

The stage 31A includes the insulating substrate 10, the capacitor 4, the diode 5, an input part 14, and the output part 13. An example of the insulating substrate 10 is a printed circuit board. In the stage 31A, the capacitor 4 and the diode 5 are disposed on both surfaces of the insulating substrate 10. The example of FIG. 5 illustrates a case where a plurality of the diodes 5 are disposed on the upper surface of the insulating substrate 10, and a plurality of the capacitors 4 are disposed on the lower surface of the insulating substrate 10.

In the voltage generator 100, the insulating substrate 10 on which components such as the capacitors 4 and the diodes 5 are mounted is fixed to the outer peripheral container 30 with an insulator such as resin, thereby forming the CW circuit 1 as a booster circuit. Note that although FIG. 5 illustrates the positions where the capacitors 4 and the diodes 5 are disposed, the positions where the capacitors 4 and the diodes 5 are disposed are not limited to those illustrated in FIG. 5.

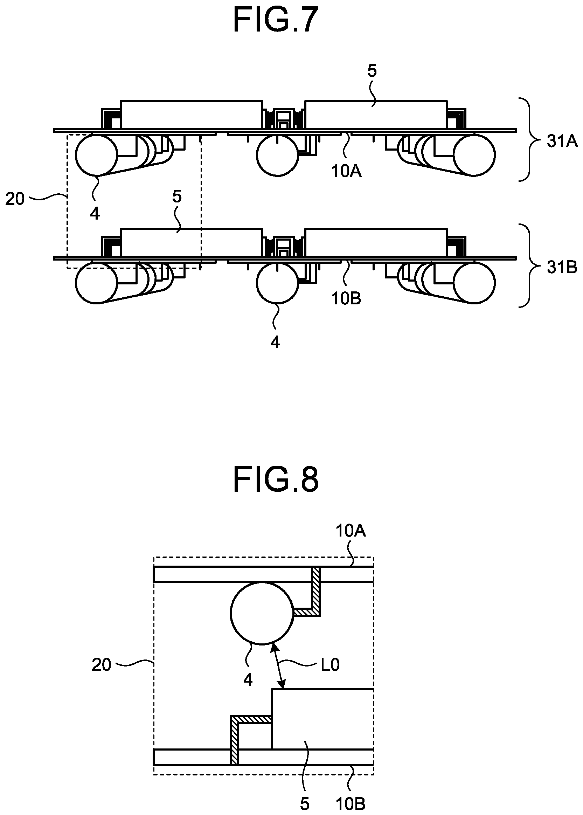

FIG. 7 is a diagram for explaining a positional relationship between the stages included in the voltage generator according to the first embodiment. FIG. 8 is a diagram for explaining a distance between components of the stages illustrated in FIG. 7.

Note that since the positional relationship between the stages 31A and 31B is similar to the positional relationship between the stages 31B and 31C, the positional relationship between the stages 31A and 31B will be described here. FIG. 7 illustrates a side view of the stages 31A and 31B, and FIG. 8 schematically illustrates an enlarged view of a region 20 of the stages 31A and 31B. In the following description, the insulating substrate of the stage 31A is referred to as an insulating substrate 10A, and the insulating substrate of the stage 31B is referred to as an insulating substrate 10B.

As illustrated in FIG. 7, the capacitor 4 as a component is disposed on the lower surface of the stage 31A stacked on the upper side, and the diode 5 as a component is disposed on the upper surface of the stage 31B on the lower side, whereby the capacitor 4 of the stage 31A and the diode 5 of the stage 31B face each other.

Of the insulating substrates 10A and 10B, one that serves as the first insulating substrate has an upper surface as a first main surface and a lower surface as a second main surface. Of the insulating substrates 10A and 10B, one that serves as the second insulating substrate has an upper surface as a third main surface and a lower surface as a fourth main surface.

A component disposed on the first main surface is a first component, and a component disposed on the second main surface is a second component. A component disposed on the third main surface is a third component, and a component disposed on the fourth main surface is a fourth component. The first to fourth components may be the capacitor 4 or the diode 5. In the case of the stage 31A illustrated in FIG. 7, the diode 5 disposed on the upper surface of the insulating substrate 10 is the first component, and the capacitor 4 disposed on the lower surface of the insulating substrate 10 is the second component. Also, in the case of the stage 31B, the diode 5 disposed on the upper surface of the insulating substrate 10 is the third component, and the capacitor 4 disposed on the lower surface of the insulating substrate 10 is the fourth component.

As illustrated in FIG. 8, the distance between the stages 31A and 31B is the shortest between the capacitor 4 mounted on the lower surface of the insulating substrate 10A stacked on the upper side and the diode 5 mounted on the upper surface of the insulating substrate 10B on the lower side. In FIG. 8, the distance between the capacitor 4 of the insulating substrate 10A and the diode 5 of the insulating substrate 10B is indicated by a distance "L0".

In order to prevent the occurrence of discharge between the insulating substrates 10A and 10B, it is necessary to increase the distance between the components of the insulating substrates 10A and 10B or appropriately design the outer shapes of the insulating substrates 10A and 10B so that the electric field is reduced. In the present embodiment, the electric field is reduced by appropriately designing the outer shapes of the insulating substrates 10A and 10B.

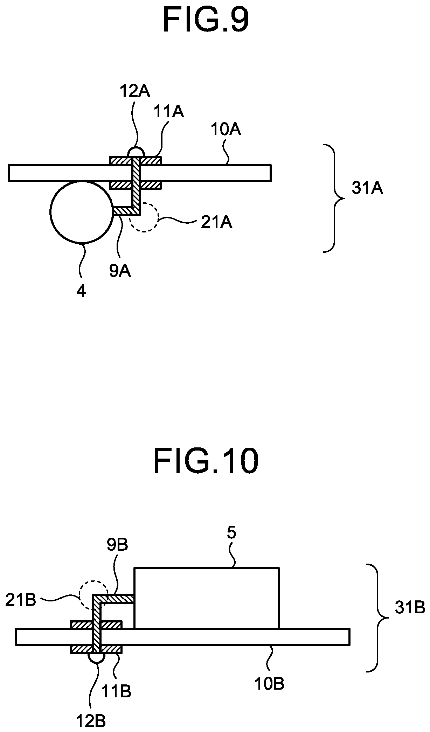

FIG. 9 is an enlarged view of the part where the capacitor is disposed in the stage on the upper side illustrated in FIG. 8. FIG. 10 is an enlarged view of the part where the diode is disposed in the stage on the lower side illustrated in FIG. 8. FIGS. 9 and 10, and FIGS. 11 to 13 to be described later schematically illustrate a side surface of the stage when the stage is viewed from the direction indicated by "A" in FIG. 5.

As illustrated in FIG. 9, a through hole is formed in the insulating substrate 10A from the upper surface to the lower surface. The capacitor 4 is disposed on the lower surface of the insulating substrate 10A, and the lead 9A connected to the capacitor 4 is passed through the through hole from the side of the lower surface of the insulating substrate 10A and drawn out to the side of the upper surface of the insulating substrate 10A. On the upper surface of the insulating substrate 10A, a copper foil pattern 11A, which is an example of a conductive pattern, is placed around the through hole. The copper foil pattern 11A and the lead 9A are joined by solder 12A on the upper surface of the insulating substrate 10A. As a result, the capacitor 4 is joined to a conductive portion (not illustrated) disposed on the insulating substrate 10A.

Moreover, as illustrated in FIG. 10, a through hole is formed in the insulating substrate 10B from the upper surface to the lower surface. The diode 5 is disposed on the upper surface of the insulating substrate 10B, and the lead 9B connected to the diode 5 is passed through the through hole from the side of the upper surface of the insulating substrate 10B and drawn out to the side of the lower surface of the insulating substrate 10B. On the lower surface of the insulating substrate 10B, a copper foil pattern 11B as an example of the conductive pattern is placed. The copper foil pattern 11B and the lead 9B are joined by solder 12B on the lower surface of the insulating substrate 10B. As a result, the diode 5 is joined to the insulating substrate 10B.

Note that the copper foil pattern 11A is provided on the upper surface or the lower surface of the insulating substrate 10A. Also, the copper foil pattern 11B is provided on the upper surface or the lower surface of the insulating substrate 10B. Moreover, the copper foil pattern 11A is in some cases provided on both the upper surface and the lower surface of the insulating substrate 10A. Likewise, the copper foil pattern 11B is in some cases provided on both the upper surface and the lower surface of the insulating substrate 10B. That is, the copper foil pattern 11A is provided on at least one of the upper surface and the lower surface of the insulating substrate 10A, and the copper foil pattern 11B is provided on at least one of the upper surface and the lower surface of the insulating substrate 10B.

In a case where the insulating substrate 10A is the first insulating substrate and the insulating substrate 10B is the second insulating substrate, the copper foil pattern 11A is a first conductive pattern and the copper foil pattern 11B is a second conductive pattern. In a case where the insulating substrate 10B is the first insulating substrate and the insulating substrate 10A is the second insulating substrate, the copper foil pattern 11B is the first conductive pattern and the copper foil pattern 11A is the second conductive pattern.

Discharge is less likely to occur from the body of the diode 5 covered with an insulator resin and the body of the capacitor 4 covered with an insulator resin because the bodies are the insulators, but discharge is likely to occur from the leads 9A and 9B that are conductors. In addition, the lead 9A needs to be bent when the capacitor 4 is mounted on the insulating substrate 10A, and the lead 9B needs to be bent when the diode 5 is mounted on the insulating substrate 10B. The bent portion (hereinafter referred to as a lead forming portion 21A) of the lead 9A and the bent portion (hereinafter referred to as a lead forming portion 21B) of the lead 9B may have an acute angle and are likely to have a high electric field.

In a case where the insulating substrate 10A is the first insulating substrate and the insulating substrate 10B is the second insulating substrate, the lead forming portion 21A is the first conductive pattern and the lead forming portion 21B is the second conductive pattern. In a case where the insulating substrate 10B is the first insulating substrate and the insulating substrate 10A is the second insulating substrate, the lead forming portion 21B is the first conductive pattern and the lead forming portion 21A is the second conductive pattern.

Since a part between the lead forming portion 21A of the capacitor 4 mounted on the lower surface of the insulating substrate 10A on the upper side and the lead forming portion 21B of the diode 5 mounted on the upper surface of the insulating substrate 10B on the lower side is the part corresponding to the shortest distance between the stages 31A and 31B, where the lead forming portions 21A and 21B are likely to have an acute angle, the part can be said to be the part having a high electric field.

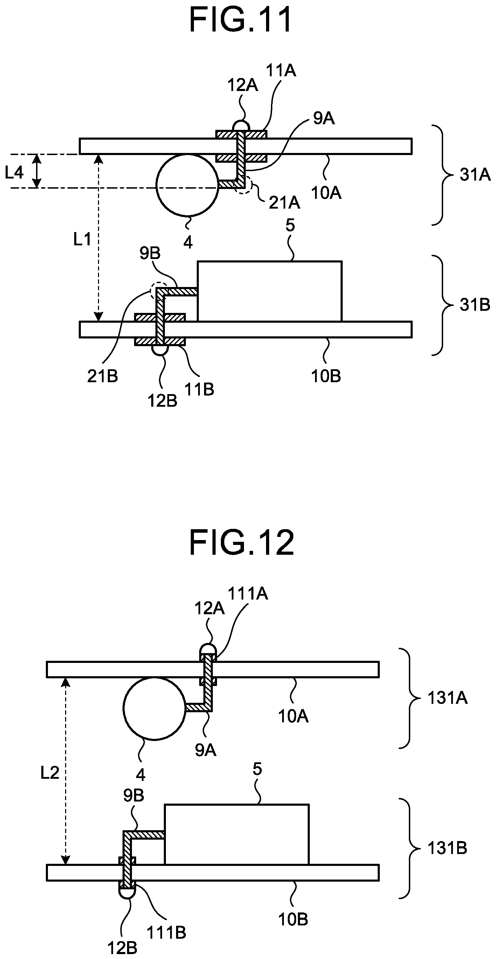

In the present embodiment, the copper foil patterns 11A and 11B are spread such that the electric field is reduced in the part that is likely to have a high electric field (likely to have discharge). FIG. 11 is a diagram for explaining formation of the copper foil patterns of the stages included in the voltage generator according to the first embodiment.

Note that although the copper foil pattern 11A cannot be placed in the through hole itself on the stage 31A because the through hole is hollow, the present embodiment will describe a structure of the stage 31A assuming that the copper foil pattern 11A is also placed in the part where the through hole is provided. Therefore, the area of the copper foil pattern 11A is an area obtained by adding together the area of the through hole when the through hole is viewed from above and the area of the copper foil pattern 11A itself when the copper foil pattern 11A is viewed from above.

Likewise, although the copper foil pattern 11B cannot be placed in the through hole itself on the stage 31B because the through hole is hollow, the present embodiment will describe a structure of the stage 31B assuming that the copper foil pattern 11B is also placed in the part where the through hole is provided. Therefore, the area of the copper foil pattern 11B is an area obtained by adding together the area of the through hole when the through hole is viewed from above and the area of the copper foil pattern 11B itself when the copper foil pattern 11B is viewed from above.

The copper foil patterns 11A and 11B of the present embodiment are applied to the lead forming portions 21A and 21B having a high electric field.

As for the stage 31A, when the stage 31A is viewed from above, the copper foil pattern 11A in the part where the capacitor 4 is bonded with the solder 12A is spread so as to cover the lead forming portion 21A that can be an origin of discharge. That is, in the stage 31A, when the stage 31A is viewed from above, the copper foil pattern 11A is placed such that the lead forming portion 21A is invisible due to the copper foil pattern 11A.

As for the stage 31B, when the stage 31B is viewed from below, the copper foil pattern 11B in the part where the diode 5 is bonded with the solder 12B is spread so as to cover the lead forming portion 21B that can be an origin of discharge. That is, in the stage 31B, when the stage 31B is viewed from below, the copper foil pattern 11B is placed such that the lead forming portion 21B is invisible due to the copper foil pattern 11B.

The size of the copper foil pattern 11A on the insulating substrate 10A is a size that can cover a section of the lead 9A when the lead 9A is cut along a plane parallel to the insulating substrate 10A. In a case where the cross-sectional area of the lead 9A is 1 mm², the size of the copper foil pattern 11A is 10mm×10mm(=100mm²) or more, for example. That is, the area of the region where the copper foil pattern 11A is placed is 100 times or more the cross-sectional area of the lead 9A.

Here, there is an effect of reducing the electric field when the area of the copper foil pattern 11A is larger than a lead sectional area that is the cross-sectional area of the lead 9A, and the effect of reducing the electric field is greater as the area of the copper foil pattern 11A is larger than the lead sectional area and the lead forming portion 21A is closer to the copper foil pattern 11A. Furthermore, when the distance from the upper surface or the lower surface of the insulating substrate 10A to the bent portion of the lead 9A is a distance L4, and when (distance L4)²≤(area of the copper foil pattern 11A) is satisfied, the effect of reducing the electric field further increases.

In addition, when (distance L4)²≤(area of the copper foil pattern 11A) is satisfied, and the inclination of the lead 9A is within ±30 degrees, the effect of reducing the electric field can be obtained without the lead component lying outside the copper foil pattern in plan view seen from a direction perpendicular to the upper surface or the lower surface of insulating substrate 10A. This makes it possible to obtain the effect of reducing the electric field even in a case where the lead 9A is inclined due to variations during production or the like.

Similarly, the size of the copper foil pattern 11B on the insulating substrate 10B is, for example, a size that can cover a section of the lead 9B when the lead 9B is cut along a plane parallel to the insulating substrate 10B. In a case where the cross-sectional area of the lead 9B is 1 mm², the size of the copper foil pattern 11B is 10mm×10mm(=100 mm²) or more, for example. That is, the area of the region where the copper foil pattern 11B is placed is 100 times or more the cross-sectional area of the lead 9B.

With such a structure, the copper foil pattern 11A can reduce the electric field of the lead forming portion 21A, and the copper foil pattern 11B can reduce the electric field of the lead forming portion 21B. Since the voltage generator 100 can reduce the electric fields of the lead forming portions 21A and 21B, a distance L1 between the insulating substrates 10A and 10B can be reduced.

The copper foil pattern 11A has higher effect of reducing the electric field as its area is larger than that of a portion in which a high electric field is generated (such as the lead forming portion 21A), and the copper foil pattern 11B has higher effect of reducing the electric field as its area is larger than that of a portion in which a high electric field is generated (such as the lead forming portion 21B).

Note that the copper foil pattern 11A need only be placed on at least one of the upper surface and the lower surface of the insulating substrate 10A. Also, the copper foil pattern 11B need only be placed on at least one of the upper surface and the lower surface of the insulating substrate 10B.

The distance between the copper foil pattern 11A and the lead forming portion 21A is shorter when the copper foil pattern 11A is placed only on the lower surface of the insulating substrate 10A than when the copper foil pattern 11A is placed only on the upper surface of the insulating substrate 10A. Therefore, the effect of reducing the electric field of the lead forming portion 21A is higher when the copper foil pattern 11A is placed only on the lower surface of the insulating substrate 10A than when placed only on the upper surface thereof.

Similarly, the distance between the copper foil pattern 11B and the lead forming portion 21B is shorter when the copper foil pattern 11B is placed only on the upper surface of the insulating substrate 10B than when the copper foil pattern 11B is placed only on the lower surface of the insulating substrate 10B. Therefore, the effect of reducing the electric field of the lead forming portion 21B is higher when the copper foil pattern 11B is placed only on the upper surface of the insulating substrate 10B than when placed only on the lower surface thereof.

Note that the effect of reducing the electric field on the lead forming portion 21A is equivalent between the case where the copper foil pattern 11A is placed only on the lower surface of the insulating substrate 10A and the case where the copper foil pattern 11A is placed on both of the surfaces of the insulating substrate 10A.

Similarly, the effect of reducing the electric field on the lead forming portion 21B is equivalent between the case where the copper foil pattern 11B is placed only on the upper surface of the insulating substrate 10B and the case where the copper foil pattern 11B is placed on both of the surfaces of the insulating substrate 10B.

Meanwhile, the electric field of the copper foil pattern 11A itself (particularly an end surface portion thereof) becomes a problem in some cases, but by placing the copper foil patterns 11A having the same area on both of the surfaces of the insulating substrate 10A, the electric field of the copper foil pattern 11A itself can be reduced.

Similarly, the electric field of the copper foil pattern 11B itself (particularly an end surface portion thereof) becomes a problem in some cases, but by placing the copper foil patterns 11B having the same area on both of the surfaces of the insulating substrate 10B, the electric field of the copper foil pattern 11B itself can be reduced.

FIG. 12 is a diagram for explaining formation of copper foil patterns of stages included in a voltage generator of a comparative example. The voltage generator of the comparative example includes stages 131A and 131B. While the stage 31A includes the copper foil pattern 11A, the stage 131A includes a copper pattern 111A of about 1mm×1mm(=1mm²) instead of the copper foil pattern 11A. Moreover, while the stage 31B includes the copper foil pattern 11B, the stage 131B includes a copper pattern 111B of about 1mm×1mm(=1mm²) instead of the copper foil pattern 11B.

In the voltage generator of the comparative example, only the copper pattern 111B of a small size is placed on the insulating substrate 10A in order for heat to be readily transferred to the solder 12A when the insulating substrate 10A and the capacitor 4 are joined by the solder 12A. Also, only the copper pattern 111B of a small size is placed on the insulating substrate 10B in order for heat to be readily transferred to the solder 12B when the insulating substrate 10B and the diode 5 are joined by the solder 12B.

On the other hand, in the voltage generator 100 of the present embodiment, for example, the copper foil pattern 11A having an area of 400 mm² or more is placed on the insulating substrate 10A, and the copper foil pattern 11B having an area of 400 mm² or more is placed on the insulating substrate 10B. Note that the shape of an upper surface of each of the copper foil patterns 11A and 11B is preferably a circle rather than a quadrangle having an acute angle in order to reduce the electric fields of the copper foil patterns 11A and 11B themselves.

The voltage generator of the comparative example cannot reduce the electric fields of the lead forming portions 21A and 21B. Therefore, a distance L2 between the insulating substrates 10A and 10B included in the voltage generator of the comparative example has to be longer than the distance L1 between the insulating substrates 10A and 10B included in the voltage generator 100. The distance L1 between the insulating substrates 10A and 10B can be short in the voltage generator 100; therefore, the voltage generator 100 can be made smaller than the voltage generator of the comparative example.

The electric fields of the copper foil patterns 11A and 11B themselves (particularly the end surface portions thereof) become a problem in some cases, but by placing the copper foil patterns 11A and 11B on both of the surfaces of the insulating substrates 10A and 10B, the electric fields of the copper foil patterns themselves can be reduced as described above. In this case, the outer shape of each of the copper foil patterns 11A and 11B is preferably a circle rather than a quadrangle having an acute angle. The reason for that will be explained. Note that since the copper foil patterns 11A and 11B have similar structures, the formation of the copper foil pattern 11A will be described below.

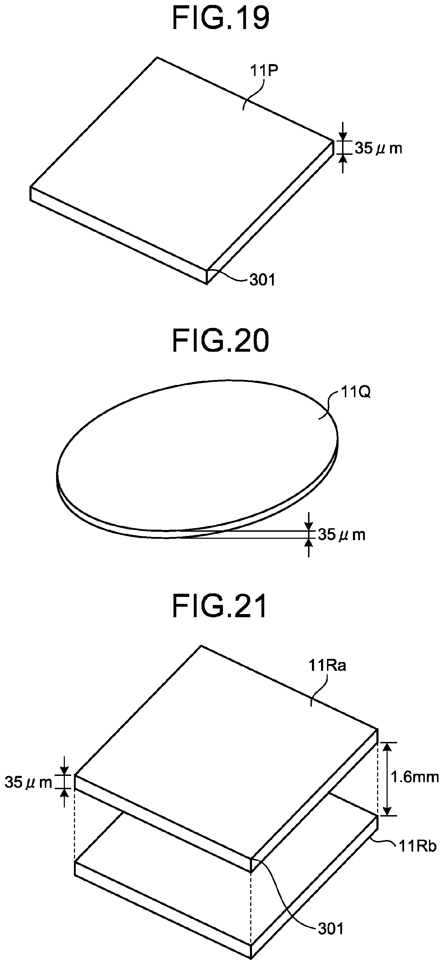

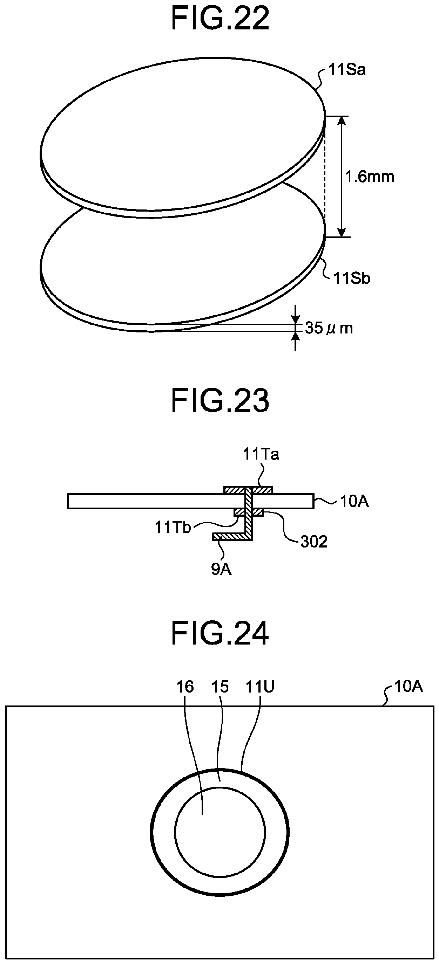

FIG. 19 is a diagram for explaining electric field concentration in a case where the copper foil pattern according to the first embodiment is placed on either the upper surface or the lower surface of the insulating substrate, and where the outer shape of the copper foil pattern is a quadrangle. FIG. 20 is a diagram for explaining electric field concentration in a case where the copper foil pattern according to the first embodiment is placed on either the upper surface or the lower surface of the insulating substrate, and where the outer shape of the copper foil pattern is a circle. FIG. 21 is a diagram for explaining electric field concentration in a case where the copper foil pattern according to the first embodiment is placed on both of the surfaces of the insulating substrate, and where the outer shape of the copper foil pattern is a quadrangle. FIG. 22 is a diagram for explaining electric field concentration in a case where the copper foil pattern according to the first embodiment is placed on both of the surfaces of the insulating substrate, and where the outer shape of the copper foil pattern is a circle.

FIG. 19 illustrates a case where the copper foil pattern 11A is a copper foil pattern 11P, and FIG. 20 illustrates a case where the copper foil pattern 11A is a copper foil pattern 11Q. Moreover, FIG. 21 illustrates a case where the copper foil pattern 11A is copper foil patterns 11Ra and 11Rb, and FIG. 22 illustrates a case where the copper foil pattern 11A is copper foil patterns 11Sa and 11Sb. FIGS. 19 to 22 illustrate perspective views of the corresponding copper foil patterns 11P, 11Q, 11Ra, Rb, 11Sa, and 11Sb.

As with the copper foil pattern 11P illustrated in FIG. 19, in the case where the copper foil pattern 11P is placed on either the upper surface or the lower surface of the insulating substrate 10A and has the quadrangular outer shape, the electric field concentration is more likely to occur at an acute angle portion 301 due to the quadrangular outer shape than in a case where the outer shape is circular. The acute angle portion 301 is a portion having an acute angle in an end portion of the copper foil pattern 11P. Moreover, in a case where the thickness of the copper foil pattern 11P is as thin as 35 µm, this thinness is also likely to cause the electric field concentration in the copper foil pattern 11P. Note that the copper foil pattern 11P may have a right angle portion in which the end portion of the copper foil pattern 11P has a right angle instead of the acute angle portion 301.

As with the copper foil pattern 11Q illustrated in FIG. 20, in the case where the copper foil pattern 11Q is placed on either the upper surface or the lower surface of the insulating substrate 10A and has the circular outer shape, there is no electric field concentration at an acute angle portion because the outer shape is circular with no acute angle portion. In this case as well, in a case where the thickness of the copper foil pattern 11Q is as thin as 35 µm, this thinness is likely to cause the electric field concentration.

The copper foil pattern 11Ra illustrated in FIG. 21 is a copper foil pattern placed on the upper surface of the insulating substrate 10A, and the copper foil pattern 11Rb is a copper foil pattern placed on the lower surface of the insulating substrate 10A. That is, the insulating substrate 10A (not illustrated in FIG. 21) is disposed between the copper foil patterns 11Ra and 11Rb. FIG. 21 illustrates a case where the thickness of each of the copper foil patterns 11Ra and 11Rb is 35 µm, and the thickness of the insulating substrate 10A is 1.6 mm. The copper foil patterns 11Ra and 11Rb have the same upper surface area and the same upper surface shape.

As with the copper foil patterns 11Ra and 11Rb illustrated in FIG. 21, in the case where the copper foil patterns 11Ra and 11Rb are placed on both of the surfaces of the insulating substrate 10A, the copper foil patterns 11Ra and 11Rb on both of the surfaces have the same potential. In a case where the insulating substrate 10A is thicker than the copper foil patterns 11Ra and 11Rb, the copper foil patterns 11Ra and 11Rb can be regarded as one metal lump. Therefore, in the case where the outer shape of the copper foil patterns 11Ra and 11Rb is quadrangular, the electric field concentration is more likely to occur at the acute angle portion 301 than in a case where the outer shape is circular, but the electric field concentration due to the copper foil patterns 11Ra and 11Rb being thin can be prevented.

The copper foil pattern 11Sa illustrated in FIG. 22 is a copper foil pattern placed on the upper surface of the insulating substrate 10A, and the copper foil pattern 11Sb is a copper foil pattern placed on the lower surface of the insulating substrate 10A. That is, the insulating substrate 10A (not illustrated in FIG. 22) is disposed between the copper foil patterns 11Sa and 11Sb. FIG. 22 illustrates a case where the thickness of each of the copper foil patterns 11Sa and 11Sb is 35 µm, and the thickness of the insulating substrate 10A is 1.6 mm. The copper foil patterns 11Sa and 11Sb have the same upper surface area and the same upper surface shape.

As with the copper foil patterns 11Sa and 11Sb illustrated in FIG. 22, in the case where the copper foil patterns 11Sa and 11Sb are placed on both of the surfaces of the insulating substrate 10A, the copper foil patterns 11Sa and 11Sb on both of the surfaces have the same potential. In a case where the insulating substrate 10A is thicker than the copper foil patterns 11Sa and 11Sb, the copper foil patterns 11Sa and 11Sb can be regarded as one metal lump. Also, the outer shape of the copper foil patterns 11Sa and 11Sb is circular. Therefore, in the case of the copper foil patterns 11Sa and 11Sb, it is possible to prevent both the electric field concentration due to the copper foil patterns 11Sa and 11Sb being thin and the electric field concentration due to an acute angle portion.

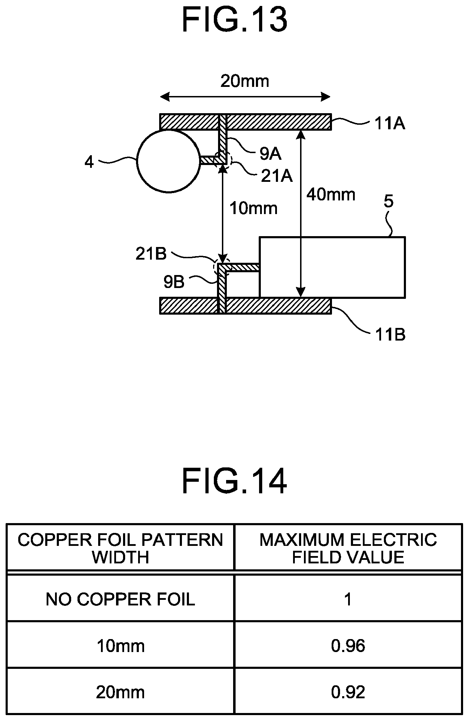

FIG. 13 is a diagram for explaining an electric field simulation model for the lead forming portions of the leads included in the voltage generator according to the first embodiment. FIG. 14 is a table illustrating a result of simulation using the electric field simulation model of FIG. 13.

In the electric field simulation model for the lead forming portions 21A and 21B, the following conditions (1) to (5) were used.
(1) The shortest distance between the lead forming portions 21A and 21B is set to 10 mm.
(2) The distance between the copper foil patterns 11A and 11B is set to 40 mm.
(3) The potential difference between the copper foil patterns 11A and 11B is set to 30 kV.
(4) The copper foil pattern 11A and the lead 9A are in a conductive state.
(5) The copper foil pattern 11B and the lead 9B are in a conductive state.

The result of simulation illustrated in FIG. 14 is the electric field intensity of the lead forming portions 21A and 21B when the width of the copper foil patterns 11A and 11B is changed using the electric field simulation model illustrated in FIG. 13. FIG. 14 indicates maximum electric field values in the lead forming portions 21A and 21B when the pattern width of the copper foil patterns 11A and 11B is 10 mm and 20 mm, and a maximum electric field value in the lead forming portions 21A and 21B when the copper foil patterns 11A and 11B are absent.

When the pattern width of the copper foil patterns 11A and 11B is 10 mm, the area of the copper foil patterns 11A and 11B is 10mm×10mm=100mm². When the pattern width of the copper foil patterns 11A and 11B is 20 mm, the area of the copper foil patterns 11A and 11B is 20mm×20mm=400mm². The result of simulation in FIG. 14 indicates the maximum electric field values in a case where the maximum value of the electric field in the absence of the copper foil patterns 11A and 11B is normalized to 1.

From the result of simulation, it can be seen that the wider the copper foil patterns 11A and 11B, the more the electric fields of the lead forming portions 21A and 21B can be reduced. This is because, by spreading the copper foil patterns 11A and 11B so as to cover the lead forming portions 21A and 21B, the electric fields of the copper foil patterns 11A and 11B become dominant over that of the lead forming portions 21A and 21B in the space of the discharge candidates, so that the magnitude of the electric fields of the lead forming portions 21A and 21B does not stand out.

Now, as described above, the capacitors 4 and the diodes 5 being the components of the voltage generator 100 are the components having low withstand voltages, but the voltage is stepped up in the CW circuit 1 to be higher as it nears the output part 13. As a result, the voltage generator 100 has a low-voltage part and a high-voltage part, and a large potential difference is generated between the low-voltage part and the high-voltage part.

For example, discharge is likely to occur between the terminals or between the high-voltage part and the outer peripheral container 30. The reduction in size and thickness of the voltage generator has a trade-off relationship with insulation reliability, so that in the case of the voltage generator of the comparative example, it has been necessary to shorten the distance between the insulating substrates 10A and 10B or the like in order to prevent the occurrence of discharge.

In the present embodiment, even with a fixed potential difference between two points being the discharge candidates, discharge can be prevented by appropriately designing the outer shape of at least one of the two points being the discharge candidates even when the distance between the two points is reduced. That is, by spreading the copper foil patterns 11A and 11B, discharge in the lead forming portions 21A and 21B can be prevented even when the lead forming portions 21A and 21B are brought close to each other. This can reduce the distance between the stages 31A and 31B while preventing discharge, and thus can downsize the voltage generator 100. Moreover, the electronic components do not need to be integrally molded with a resin molding material, whereby an increase in weight of the voltage generator 100 can be prevented.

There is a CW circuit in which one capacitor and another capacitor connected in series therewith are electrically connected at a connection portion, a diode is connected to the connection portion, and the connection portion is disposed between end electrodes of the capacitors to reduce an electric field of the connection portion. In this CW circuit, there is no effect of electric field reduction unless the connection portion is disposed between the electrodes of the capacitors without lying outside the electrodes. Moreover, it is difficult to apply this CW circuit to a radial capacitor, and a mounting method is limited depending on the type of the capacitor. In addition, there is no effect unless the components are disposed only on the same surface of an insulating substrate, which results in an increase in the area of the insulating substrate.

Meanwhile, in the voltage generator 100 of the present embodiment, there is no problem even when the connection point connecting the capacitors 4 lies outside the electrodes of the capacitors 4. Also, in the voltage generator 100, the capacitor 4 of the CW circuit 1 may be of an axial type or a radial type. Furthermore, in the voltage generator 100, the components such as the capacitor 4 and the diode 5 can be disposed on both of the surfaces of the insulating substrate 10A and both of the surfaces of the insulating substrate 10B. As a result, the insulating substrate 10A and the insulating substrate 10B can be reduced in size.

As described above, in the first embodiment, when the insulating substrate 10A is viewed from the side of the upper surface of the insulating substrate 10A, the copper foil pattern 11A is spread to the region covering the lead forming portion 21A of the lead 9A. As a result, the CW circuit 1 that is downsized can be obtained without an increase in weight of the insulating substrates 10A and 10B being stacked. When the insulating substrate 10B is viewed from the side of the lower surface of the insulating substrate 10B, the copper foil pattern 11B is spread to the region covering the lead forming portion 21B of the lead 9B. As a result, the CW circuit 1 that is further downsized can be obtained without an increase in weight of the insulating substrates 10A and 10B being stacked.

### Second Embodiment.

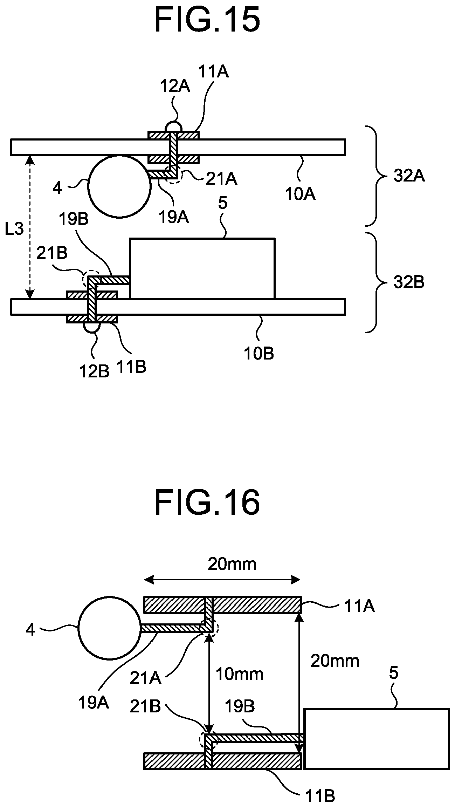

Next, a second embodiment of the present invention will be described with reference to FIGS. 15 to 18. In the second embodiment, the distance between the lead forming portion 21A and the copper foil pattern 11A is made shorter than that in the case of the first embodiment. Also, the distance between the lead forming portion 21B and the copper foil pattern 11B is made shorter than that in the case of the first embodiment.

FIG. 15 is a diagram for explaining a configuration of stages included in a voltage generator according to the second embodiment. Components in FIG. 15 that achieve the same functions as those of the stages 31A and 31B of the first embodiment illustrated in FIG. 11 are denoted by the same reference numerals as those assigned to the corresponding components in FIG. 11, and thus redundant description will be omitted. FIG. 15 and FIGS. 16 and 18 to be described later schematically illustrate side surfaces of the stages.

A stage 32A uses a lead 19A in place of the lead 9A, and a stage 32B uses a lead 19B in place of the lead 9B. The lead 19A is a lead in which the length of a portion extending perpendicularly to the copper foil pattern 11A is shorter than that of the lead 9A. The lead 19B is a lead in which the length of a portion extending perpendicularly to the copper foil pattern 11B is shorter than that of the lead 9B. Therefore, in the stage 32A, the distance between the lead forming portion 21A and the copper foil pattern 11A is shorter than that in the stage 31A. Likewise, in the stage 32B, the distance between the lead forming portion 21B and the copper foil pattern 11B is shorter than that in the stage 31B. The cross-sectional area of the lead 19A is the same as the cross-sectional area of the lead 9A, and the cross-sectional area of the lead 19B is the same as the cross-sectional area of the lead 9B.

In the stage 32A, the length of the portion extending perpendicularly to the copper foil pattern 11A is reduced by connecting the capacitor 4 and the lead 19A at a position closer to the insulating substrate 10A. For example, in the stage 32A, the capacitor 4 and the lead 19A are connected at a position closer to the insulating substrate 10A with respect to a central portion in a height direction of the capacitor 4.

Similarly, in the stage 32B, the length of the portion extending perpendicularly to the copper foil pattern 11B is reduced by connecting the diode 5 and the lead 19B at a position closer to the insulating substrate 10B. For example, in the stage 32B, the diode 5 and the lead 19B are connected at a position closer to the insulating substrate 10B with respect to a central portion in a height direction of the diode 5. This can make a distance L3 between the insulating substrates 10A and 10B shorter than the distance L1 between the insulating substrates 10A and 10B described in the first embodiment.

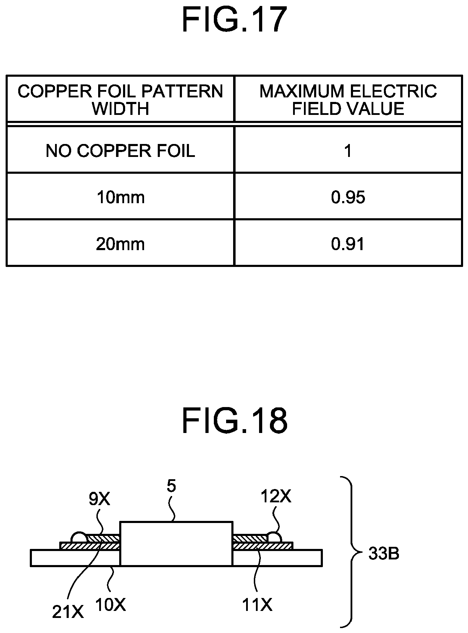

FIG. 16 is a diagram for explaining an electric field simulation model for the lead forming portions of the leads included in the voltage generator according to the second embodiment. FIG. 17 is a table illustrating a result of simulation using the electric field simulation model of FIG. 16.

In the electric field simulation model for the lead forming portions 21A and 21B, the following conditions (6) to (10) were used.
(6) The shortest distance between the lead forming portions 21A and 21B is set to 10 mm.
(7) The distance between the copper foil patterns 11A and 11B is set to 20 mm.
(8) The potential difference between the copper foil patterns 11A and 11B is set to 30 kV.
(9) The copper foil pattern 11A and the lead 91A are in a conductive state.
(10) The copper foil pattern 11B and the lead 19B are in a conductive state.

That is, while the distance between the copper foil patterns 11A and 11B is 40 mm in the first embodiment, the distance between the copper foil patterns 11A and 11B is 20 mm in the second embodiment. The result of simulation illustrated in FIG. 17 is the electric field intensity of the lead forming portions 21A and 21B when the width of the copper foil patterns 11A and 11B is changed using the electric field simulation model illustrated in FIG. 16. FIG. 17 indicates maximum electric field values in the lead forming portions 21A and 21B when the pattern width of the copper foil patterns 11A and 11B is 10 mm and 20 mm, and a maximum electric field value in the lead forming portions 21A and 21B when the copper foil patterns 11A and 11B are absent.

When the pattern width of the copper foil patterns 11A and 11B is 10 mm, the area of the copper foil patterns 11A and 11B is 10mm×10mm=100mm². When the pattern width of the copper foil patterns 11A and 11B is 20 mm, the area of the copper foil patterns 11A and 11B is 20mm×20mm=400mm². The result of simulation in FIG. 17 indicates the maximum electric field values in a case where the maximum value of the electric field in the absence of the copper foil patterns 11A and 11B is normalized to 1.

From the results of simulation in FIGS. 14 and 17, it can be seen that the closer a portion in which a high electric field is generated (such as the lead forming portions 21A and 21B) to the copper foil patterns 11A and 11B, the more the electric fields of the lead forming portions 21A and 21B can be reduced. This is because, by bringing the lead forming portions 21A and 21B close to the corresponding copper foil patterns 11A and 11B, the electric fields of the copper foil patterns 11A and 11B become dominant over that of the lead forming portions 21A and 21B in the space of the discharge candidates, so that the magnitude of the electric fields of the lead forming portions 21A and 21B does not stand out.

Here, a modification of the second embodiment will be described. FIG. 18 is a diagram for explaining an example of another configuration of the stage included in the voltage generator according to the second embodiment. Here, a configuration of a stage 33B that is a modification of the stage 32B will be described.

The stage 33B includes an insulating substrate 10X, the diode 5, a lead 9X, a copper foil pattern 11X, and solder 12X. That is, the stage 33B includes the insulating substrate 10X instead of the insulating substrate 10B, the lead 9X instead of the lead 9B, the copper foil pattern 11X instead of the copper foil pattern 11B, and the solder 12X instead of the solder 12B.

Compared to the insulating substrate 10B, the insulating substrate 10X is different from the insulating substrate 10B in that a hole capable of housing the diode 5 is formed in the insulating substrate 10X. It is assumed that the lead 9X includes a lead forming portion 21X. The cross-sectional area of the lead 9X is the same as the cross-sectional area of the lead 9B.

In the stage 33B, the diode 5 is fitted into the hole provided in the insulating substrate 10X, and the insulating substrate 10X and the diode 5 are electrically connected by the lead 9X. The copper foil pattern 11X is placed between the insulating substrate 10X and the lead 9X. Specifically, a portion of the lead 9X extending in a direction parallel to an upper surface of the insulating substrate 10X is joined to the upper surface of the insulating substrate 10X.

The copper foil pattern 11X is placed around the hole into which the diode 5 is fitted, and the lead 9X is disposed on the copper foil pattern 11X. That is, when the stage 33B is viewed from below, the copper foil pattern 11X is spread so as to cover the lead 9X that is a discharge candidate. Note that the copper foil pattern 11X need not cover the entirety of the lead 9X. In this case, when the stage 33B is viewed from below, the copper foil pattern 11X is spread so as to cover the lead forming portion 21X that is highly likely to be an origin of discharge. The copper foil pattern 11X and the lead 9X are joined by the solder 12X.

The hole structure as in the stage 33B may be applied to the stage 32A. That is, a hole such as that in the stage 33B may be provided in the stage 32A as well, and with the capacitor 4 being fitted into the hole, the insulating substrate 10A and the capacitor 4 may be electrically connected by the lead 9A. In this case, a portion of the lead 9A extending in a direction parallel to the upper surface of the insulating substrate 10A is joined to the upper surface of the insulating substrate 10A.

In a case where the insulating substrate 10A is the first insulating substrate and the insulating substrate 10X is the second insulating substrate, the hole provided in the stage 32A is a first hole, and the hole provided in the stage 33B is a second hole. In a case where the insulating substrate 10X is the first insulating substrate and the insulating substrate 10A is the second insulating substrate, the hole provided in the stage 33B is the first hole, and the hole provided in the stage 32A is the second hole.

The configuration of the stage 33B illustrated in FIG. 18 allows the lead 9X and the lead forming portion 21X to be brought close to the copper foil pattern 11X. As a result, the distance between the stages being stacked can be reduced.

Note that when the solder 12X is bonded to the insulating substrate 10X, the solder 12X may be bonded to a land pattern on the surface, or a through hole may be formed as in the insulating substrates 10A and 10B of the first embodiment so that the solder 12X may be bonded from the lower surfaces of the insulating substrates 10A and 10B.

Moreover, the example of FIG. 18 has described the case where the diode 5 is embedded in the insulating substrate 10X, but any lead component may be embedded in the insulating substrate 10X regardless of the type of component. For example, the capacitor 4 may be embedded in the insulating substrate 10X.

The distance between an edge of the lead forming portion 21X disposed on the insulating substrate 10X and the copper foil pattern 11X varies depending on the size of the component. For example, in a case where the diode 5 embedded in the insulating substrate 10X is thicker than the insulating substrate 10X, the diode 5 protrudes from the upper surface of the insulating substrate 10X, and thus the distance between the edge of the lead forming portion 21X and the copper foil pattern 11X is long. In a case of a film capacitor with a width of 100 mm and Φ 20 mm, the distance between the edge of the lead forming portion 21X and the copper foil pattern 11X is 10 mm.

The configuration of the first embodiment can make the distance between the stages shorter than previously possible, and the configuration of the second embodiment can make the distance between the stages even shorter. In the second embodiment, the shorter the distance between the edge of the lead forming portion 21X and the copper foil pattern 11X is, the shorter the distance between the stages can be, and the voltage generator 100 can be downsized.

As described above, according to the second embodiment, since the component such as the diode 5 is embedded in the insulating substrate 10X, the distance between the stages can be made shorter than in the case of the first embodiment. Therefore, the voltage generator 100 can be downsized more than in the case of the first embodiment.

### Third Embodiment.

Next, a third embodiment will be described with reference to FIG. 23. The first embodiment has described the case where the copper foil patterns 11A and 11B are placed on both of the surfaces of the corresponding insulating substrates 10A and 10B, the copper foil patterns 11A and 11B on both of the surfaces having the same area and having the circular outer shape. As a result, the copper foil patterns 11A and 11B can reduce both the electric fields of the lead forming portions 21A and 21B and the electric fields of the end surface portions being the side surfaces of the copper foil patterns 11A and 11B.

However, due to manufacturing variations or design restrictions, the copper foil patterns 11A on both of the surfaces cannot always have the same area, and the copper foil patterns 11B on both of the surfaces cannot always have the same area. That is, the copper foil pattern 11Ra and the copper foil pattern 11Rb illustrated in FIG. 21 cannot always have the same area. Likewise, the copper foil pattern 11Sa and the copper foil pattern 11Sb illustrated in FIG. 22 cannot always have the same area.

Thus, in the third embodiment, the copper foil pattern to be placed on the upper surface of the insulating substrate is designed to be larger than the copper foil pattern to be placed on the lower surface, and the copper foil patterns are placed such that the copper foil pattern placed on the upper surface of the insulating substrate can cover the copper foil pattern placed on the lower surface. Note that since the copper foil patterns 11A and 11B have similar structures, the formation of the copper foil pattern 11A will be described below.

FIG. 23 is a diagram illustrating formation of copper foil patterns according to the third embodiment. FIG. 23 illustrates a case where the copper foil pattern 11A is copper foil patterns 11Ta and 11Tb. Since the copper foil patterns 11Ta and 11Tb have manufacturing variations, it is difficult to make upper surfaces of the copper foil patterns 11Ta and 11Tb have the same area and the same shape completely. Therefore, the areas and shapes of the copper foil patterns 11Ta and 11Tb are designed in consideration of the manufacturing variations in advance. That is, the areas and shapes of the copper foil patterns 11Ta and 11Tb are designed such that, when viewed from the side of the upper surface of the copper foil pattern 11Ta, the copper foil pattern 11Ta can encompass the entire surface of the copper foil pattern 11Tb. Then, the copper foil patterns 11Ta and 11Tb are placed such that, when viewed from the side of the upper surface of the copper foil pattern 11Ta, the copper foil pattern 11Ta can encompass the entire surface of the copper foil pattern 11Tb. As a result, when viewed from the side of the upper surface of the copper foil pattern 11Ta, an end surface portion 302 of the copper foil pattern 11Tb is covered by the copper foil pattern 11Ta. With such formation, the copper foil patterns 11Ta and 11Tb can reduce the electric fields of the lead forming portions 21A and 21B and the electric field of the end surface portion 302 of the copper foil pattern 11Tb placed on the lower surface.

Note that the outer shapes, that is, the upper surfaces of the copper foil patterns 11Ta and 11Tb may be circular or quadrangular.

Here, among the end surface portions of the copper foil patterns 11Ta and 11Tb, the electric field can be reduced for the end surface portion of only the copper foil pattern 11Tb placed on the lower surface, and the electric field of the copper foil pattern 11Ta placed on the upper surface cannot be reduced. Therefore, it can be said that the method of reducing the electric field using the copper foil patterns 11Ta and 11Tb is a method of preferentially reducing the electric field of the end surface portion 302 of the copper foil pattern 11Tb placed on the lower surface. Even with this method, the copper foil pattern 11Ta is farther from the lead forming portion 21A than the copper foil pattern 11Tb. Therefore, even if partial discharge occurs between the end surface portion of the copper foil pattern 11Ta and the lead forming portion 21A, flashover, that is, complete discharge, is less likely to occur because the insulating substrate 10A is interposed therebetween.

The reason why the electric field of the end surface portion 302 of the copper foil pattern 11Tb can be reduced by the area of the copper foil pattern 11Ta being larger than the area of the copper foil pattern 11Tb is the same as the reason why the electric field of the lead forming portion 21A can be reduced by the copper foil pattern 11A. Thus, as for the copper foil patterns 11Ta and 11Tb, the copper foil pattern 11Ta on the upper surface, which is placed so as to encompass the copper foil pattern 11Tb on the lower surface, can make the electric field of the end surface portion 302 of the copper foil pattern 11Tb on the lower surface not stand out.

As described above, in the third embodiment, the copper foil pattern 11Ta to be placed on the upper surface of the insulating substrate 10A is designed to be larger than the copper foil pattern 11Tb to be placed on the lower surface. Then, the copper foil patterns 11Ta and 11Tb are placed such that, when viewed from the side of the upper surface of the copper foil pattern 11Ta, the copper foil pattern 11Ta covers the entirety of the copper foil pattern 11Tb. As a result, the distance between the stages can be shorter than in the case of the first embodiment. Therefore, the voltage generator 100 can be downsized more than in the case of the first embodiment.

### Fourth Embodiment.

Next, a fourth embodiment will be described with reference to FIGS. 24 to 26. In the fourth embodiment, solder is put in an outer peripheral portion of a copper foil pattern placed on the upper surface of the insulating substrate 10A, thereby reducing the electric field at an end surface portion of the copper foil pattern placed on the upper surface of the insulating substrate 10A. Note that since the copper foil patterns 11A and 11B have similar structures, the formation of the copper foil pattern 11A will be described below.

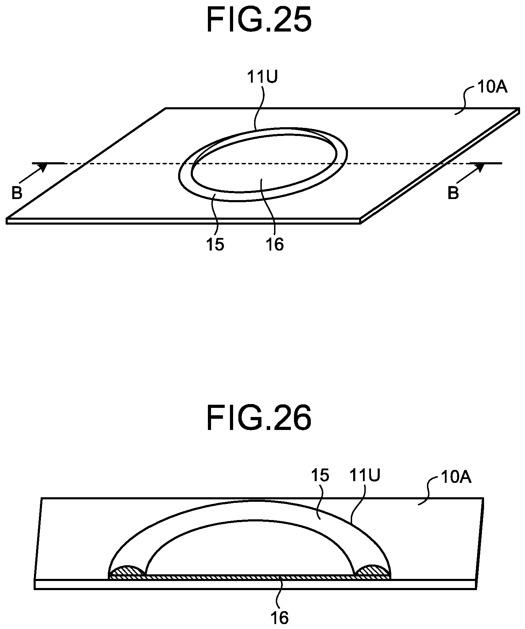

FIG. 24 is a top view illustrating formation of the copper foil pattern according to the fourth embodiment. FIG. 25 is a perspective view illustrating formation of the copper foil pattern according to the fourth embodiment. FIG. 26 is a perspective view illustrating formation of the copper foil pattern when the copper foil pattern illustrated in FIG. 25 is cut along line B-B. FIGS. 24 to 26 illustrate a case where the copper foil pattern 11A is a copper foil pattern 11U. FIG. 26 illustrates one part of the copper foil pattern 11U that has been cut and omits the illustration of the other part thereof.

The copper foil pattern 11U includes a solder portion 15 and a copper foil portion 16. The copper foil portion 16 has a circular shape when the copper foil pattern 11U is viewed from above. The solder portion 15 is placed in an annular region that is an outer peripheral portion of the copper foil portion 16.

When the copper foil pattern 11U is produced, the copper foil portion 16 having the circular shape is formed on the upper surface of the insulating substrate 10A. A resist is applied to the upper surface of the insulating substrate 10A so as to cover the entire upper surface of the insulating substrate 10A. As a result, an upper surface of the copper foil portion 16 is covered with the resist. The resist is peeled off only in the annular region that is the outer peripheral portion of the copper foil portion 16. In other words, the resist on the insulating substrate 10A is peeled off only in an end portion of the copper foil portion 16. Then, solder is put only in the annular region that is the region where the resist has been peeled off. The solder put in the annular region is the solder portion 15. After the solder portion 15 is formed, the remaining resist is peeled off from the insulating substrate 10A.

In the copper foil pattern 11U, even in a case where the copper foil portion 16 is thin and electric field concentration is likely to occur, the solder portion 15 is put at the position corresponding to an end surface portion of the copper foil portion 16, thereby thickening a position corresponding to an end surface portion of the copper foil pattern 11U. As a result, the electric field at the end surface portion of the copper foil pattern 11U is reduced. Note that the electric field can be further reduced by putting the solder such that the solder portion 15 does not have any acute portion.

Note that the copper foil pattern 11U may be placed on both of the surfaces of the insulating substrate 10A. In a case where the copper foil pattern 11U is placed on both of the surfaces of the insulating substrate 10A, the solder portion 15 is placed on both of the surfaces of the insulating substrate 10A. Note that the solder portion 15 may be placed on only one of the upper surface and the lower surface of the insulating substrate 10A. Also, in the case where the copper foil pattern 11U is placed on both of the surfaces of the insulating substrate 10A, the size of the copper foil pattern 11U placed on the upper surface may be larger than or equal to that of the copper foil pattern 11U placed on the lower surface. Moreover, the upper surface of the copper foil portion 16 may have a quadrangular shape. In this case, the solder portion 15 has a quadrangular annular shape. Also, the solder portion 15 may be applied to the copper foil pattern described in the first to third embodiments.

Furthermore, the copper foil portion 16 need not be provided under the solder portion 15. In this case, the copper foil portion 16 is formed slightly smaller, and the solder portion 15 having an annular shape is formed so as to be in contact with the end surface portion of the copper foil portion 16 in an outer region of the copper foil portion 16.

As described above, in the fourth embodiment, the solder portion 15 is provided in the outer peripheral region of the copper foil pattern 11U, so that the electric field at the end surface portion of the copper foil pattern 11U can be reduced even in a case where the copper foil portion 16 is thin.

The configuration illustrated in the above embodiment merely illustrates an example of the content of the present invention, and can thus be combined with another known technique or partially omitted and/or modified without departing from the scope of the present invention.

### Reference Signs List

1 CW circuit; 2 inverter circuit; 3A, 3B step-up transformer; 4 capacitor; 5, D101 to D113, D201 to D213, Da1, Da2, Db1 to Db4 diode; 6 column; 7 base plate; 9A, 9B, 9X, 19A, 19B lead; 10, 10A, 10B, 10X insulating substrate; 11A, 11B, 11P, 11Q, 11Ra, 11Rb, 11Sa, 11Sb, 11Ta, 11Tb, 11U, 11X copper foil pattern; 12A, 12B, 12X solder; 13 output part; 14 input part; 15 solder portion; 16 copper foil portion; 21A, 21B, 21X lead forming portion; 30 outer peripheral container; 31A to 31C, 32A, 32B, 33B, 131A, 131B stage; 50 rectifier circuit unit; 51X, 51Y connection line; 60 voltage doubler booster circuit unit; 61 to 64 connection point; 100 voltage generator; 111A, 111B copper pattern; 301 acute angle portion; 302 end surface portion; C01 to C07, Ca, Cb1 direct current capacitor; C11 to C16, C21 to C26, Cb2, Cb3 alternating current capacitor; E1, E2 alternating current power supply; T1 to T3 input terminal.

## Claims

1. A booster circuit to boost an input voltage, the booster circuit comprising:
a first insulating substrate having a first component disposed on a first main surface and a second component disposed on a second main surface;
a second insulating substrate having a third component disposed on a third main surface;
a first lead connected to the second component; and
a connection line to connect the first insulating substrate and the second insulating substrate, wherein
the first insulating substrate and the second insulating substrate are stacked such that the second main surface faces the third main surface,
a first conductive pattern that connects the first lead to a conductive member disposed on the first insulating substrate is placed on at least one of the first main surface and the second main surface, and
when the first insulating substrate is viewed from a side of the first main surface, the first conductive pattern is spread to a region covering a first lead forming portion that is a bent portion of the first lead.

2. The booster circuit according to claim 1, wherein
an area of the region in which the first conductive pattern is placed is 100 times or more a cross-sectional area of the first lead.

3. The booster circuit according to claim 1 or 2, wherein
the first insulating substrate is provided with a first hole that houses the second component, and the second component is housed in the first hole.

4. The booster circuit according to claim 3, wherein
a portion of the first lead extending in a direction parallel to the second main surface is joined to the second main surface.

5. The booster circuit according to any one of claims 1 to 4, wherein
the second insulating substrate has a fourth main surface on which a fourth component is disposed,
the booster circuit further comprises a second lead connected to the fourth component,
a second conductive pattern that connects the second lead to a conductive member disposed on the second insulating substrate is placed on the third main surface or the fourth main surface, and
when the second insulating substrate is viewed from a side of the fourth main surface, the second conductive pattern is spread to a region covering a second lead forming portion that is a bent portion of the second lead.

6. The booster circuit according to claim 5, wherein
an area of the region in which the second conductive pattern is placed is 100 times or more a cross-sectional area of the second lead.

7. The booster circuit according to claim 6, wherein
the second insulating substrate is provided with a second hole that houses the third component, and the third component is housed in the second hole.

8. The booster circuit according to claim 7, wherein
a portion of the second lead extending in a direction parallel to the third main surface is joined to the third main surface.

9. The booster circuit according to any one of claims 1 to 8, wherein
the first component, the second component, and the third component are components of a Cockcroft-Walton circuit.

10. The booster circuit according to any one of claims 5 to 8, wherein
when the first conductive pattern is placed on both the first main surface and the second main surface, an area of the first conductive pattern placed on the first main surface is larger than an area of the second conductive pattern placed on the second main surface.

11. The booster circuit according to any one of claims 1 to 10, wherein
a solder portion is put in an outer peripheral region or an outer region of the first conductive pattern.

12. A voltage generator comprising:
an inverter circuit to generate an alternating current voltage;
a step-up transformer to step up an output voltage from the inverter circuit; and
a booster circuit to boost an output voltage from the step-up transformer, wherein
the booster circuit includes:
a first insulating substrate having a first component disposed on a first main surface and a second component disposed on a second main surface;
a second insulating substrate having a third component disposed on a third main surface;
a first lead connected to the second component; and
a connection line to connect the first insulating substrate and the second insulating substrate,
the first insulating substrate and the second insulating substrate are stacked such that the second main surface faces the third main surface,
a first conductive pattern that connects the first lead to a conductive member disposed on the first insulating substrate is placed on at least one of the first main surface and the second main surface, and
when the first insulating substrate is viewed from a side of the first main surface, the first conductive pattern is spread to a region covering a first lead forming portion that is a bent portion of the first lead.
